# FASCICULE DE BREVET EUROPEEN

(11) **EP 3 698 462 B1**
(45) Date de publication et mention de la délivrance du brevet: **22.09.2021**
(21) Numéro de dépôt: 18796731.0
(22) Date de dépôt: 15.10.2018
(51) Int. Cl.: H02N 2/18, H01L 41/00

(54) **RECUPERATEUR D'ENERGIE COMPRENANT UN CONVERTISSEUR A BASE DE MATERIAU PIEZOELECTRIQUE**
ENERGIEUMWANDLER MIT EINEM UMWANDLER BASIEREND AUF EINEM PIEZOELEKTRISCHEN MATERIAL
ENERGY RECOVERY COMPRISING A CONVERTER BASED ON A PIEZOELECTRIC MATERIAL

(30) Priorité: 18.10.2017 FR 1759763
(43) Date de publication de la demande: 26.08.2020
(73) Titulaire: Enerbee, 38040 Grenoble (FR)
(72) Inventeur: POUYADOU, Luc, 38190 Brignoud (FR); RICART, Thibault, 38170 Seyssinet Pariset (FR); DELAMARE, Jérôme, 38000 Grenoble (FR); SOULIE, Romain, 38000 Grenoble (FR)
(74) Mandataire: IP Trust
(86) Numéro de dépôt international: PCT/FR2018/052555
(87) Numéro de publication internationale: WO 2019/077248

(56) Documents cités:
- FR-A1- 2 997 247

## Description

### DOMAINE DE L'INVENTION

La présente invention concerne le domaine des dispositifs pour la récupération d'énergie. Elle concerne en particulier un récupérateur d'énergie comprenant un convertisseur apte à convertir une variation d'énergie à récupérer en une différence de potentiel. Le convertisseur comprend une couche de matériau piézoélectrique.

### ARRIERE PLAN TECHNOLOGIQUE DE L'INVENTION

On connaît de l'état de la technique (WO2014/063951 et WO2014/063958), des générateurs d'électricité comportant une source de champ magnétique et un récupérateur d'énergie. Ce dernier comprend un convertisseur magnéto-électrique apte à convertir une variation du champ magnétique en une différence de potentiel entre deux bornes électriques, par accumulation de charges électriques sur l'une ou l'autre desdites bornes électriques. Le convertisseur est composé d'une part, d'un transducteur électromécanique comprenant une couche piézoélectrique apte à transformer une déformation mécanique en une différence de potentiel entre ses électrodes, reliées aux deux bornes électriques ; d'autre part, il est composé d'une couche magnétostrictive fixée selon un plan de référence et sans degré de liberté au transducteur électromécanique, apte à convertir une variation du champ magnétique en une déformation mécanique, exercée sur le transducteur électromécanique. Le récupérateur d'énergie comprend également un circuit de collecte des charges, relié aux bornes électriques du convertisseur par un interrupteur ; ce dernier est commandé pour basculer en position fermée, pour permettre la récupération de toutes les charges, accumulées sur l'une des bornes électriques du convertisseur, dès que la différence de potentiel entre lesdites bornes électriques est supérieure à un seuil prédéterminé.

En fonctionnement, de tels générateurs émettent un cliquetis : cette onde sonore peut être un frein, voire même être rédhibitoire, pour certaines applications.

### OBJET DE L'INVENTION

Un objet de l'invention est de proposer une solution pour limiter voire éliminer l'onde sonore générée par les générateurs de l'état de la technique.

### BREVE DESCRIPTION DE L'INVENTION

La présente invention concerne un récupérateur d'énergie comprenant :
- un convertisseur apte à convertir une variation d'une énergie à récupérer en une différence de potentiel entre deux bornes électriques par accumulation de charges sur l'une ou l'autre desdites bornes ; le convertisseur inclut un empilement de couches avec au moins une première couche en un matériau piézoélectrique ;
- un circuit de collecte relié aux deux bornes électriques et comprenant un interrupteur, le circuit de collecte étant configuré pour récupérer les charges lorsque l'interrupteur est dans un état fermé ; le convertisseur est susceptible d'émettre des vibrations acoustiques dans une bande de fréquence audible lorsque le circuit de collecte récupère les charges ;

Le récupérateur d'énergie est remarquable en ce qu'il comprend un circuit de commande configuré pour commander une pluralité de séquences de fermeture-ouverture de l'interrupteur, lorsque la différence de potentiel atteint un seuil défini, de manière à récupérer les charges par une pluralité de décharges partielles du convertisseur et à limiter l'écart de contrainte subi par la première couche lors de chaque décharge.

Selon des caractéristiques avantageuses du convertisseur selon l'invention, prises seules ou en combinaison :
- pour chaque séquence, l'état fermé de l'interrupteur est commandé par une impulsion générée par le circuit de commande ;
- la au moins une largeur de la pluralité d'impulsions et la période desdites impulsions sont choisies de manière à contrôler la dynamique de contrainte subie par la première couche lors des décharges partielles ;
- une impulsion présente une largeur de 100 à 1000 nanosecondes et dans lequel deux impulsions de deux séquences consécutives sont espacées de 10 à 100 microsecondes ;
- le circuit de commande comprend un premier étage de détection du seuil défini de différence de potentiel, un deuxième étage de génération des impulsions et un troisième étage de commande de l'interrupteur ;
- le premier étage comprend un comparateur différentiel, connecté aux bornes électriques du convertisseur et apte à générer un premier signal de déclenchement au niveau d'une première sortie ;
- le deuxième étage comprend un dispositif logique, connecté à la première sortie et apte à générer un deuxième signal formant un train d'impulsions, au niveau d'une deuxième sortie ;
- le deuxième signal présente une largeur d'impulsions, une période d'impulsions et un nombre d'impulsions fixes ;
- le troisième étage comprend un dispositif d'adaptation, connecté à la deuxième sortie, pour transformer le deuxième signal en un signal de commande formant un train d'impulsions, apte à commander la pluralité de séquences de fermeture/ouverture de l'interrupteur ;
- le dispositif d'adaptation comprend un transistor et un transformateur d'impulsions ;
- le deuxième étage ou l'ensemble formé par le premier et le deuxième étage comprend un microcontrôleur, configuré pour générer un deuxième signal formant un train d'impulsions, au niveau d'une deuxième sortie ;
- le deuxième signal présente une largeur d'impulsions, une période d'impulsions et un nombre d'impulsions variables ;
- le convertisseur est un convertisseur magnéto-électrique apte à convertir une variation d'une énergie magnétique en une différence de potentiel entre ses deux bornes électriques et dont l'empilement de couches comprend une deuxième couche en un matériau magnétostrictif.

L'invention concerne également un générateur d'électricité comprenant une source de champ magnétique et un récupérateur d'énergie tel que ci-dessus.

### BREVE DESCRIPTION DES DESSINS

D'autres caractéristiques et avantages de l'invention ressortiront de la description détaillée de l'invention qui va suivre en référence aux figures annexées sur lesquelles :
- la figure 1 présente une illustration d'un générateur d'électricité comprenant un récupérateur d'énergie conforme à l'invention ;
- la figure 2 présente un schéma électrique d'un récupérateur d'énergie conforme à l'invention ;
- les figures 3a et 3b présentent des exemples d'évolution périodique de la différence de potentiel aux bornes électriques d'un convertisseur ;
- les figures 4a et 4b présentent des exemples d'évolution périodique de la différence de potentiel aux bornes électriques d'un convertisseur d'un récupérateur d'énergie conforme à l'invention ;
- les figures 5a et 5b présentent chacune un schéma électrique du premier étage du circuit de commande d'un récupérateur d'énergie conforme à l'invention ;
- la figure 6 présente un schéma électrique du deuxième étage du circuit de commande d'un récupérateur d'énergie conforme à l'invention ;
- la figure 7 présente un schéma électrique du troisième étage du circuit de commande d'un récupérateur d'énergie conforme à l'invention.

### DESCRIPTION DETAILLEE DE L'INVENTION

Les figures représentent des exemples de réalisation et ne doivent en aucun cas être considérées comme limitatives ; les mêmes références sur les figures pourront être utilisées pour des éléments de même nature.

La présente invention concerne un récupérateur d'énergie 90, destiné à former une partie d'un générateur d'électricité 100.

Le récupérateur d'énergie 90 comprend un convertisseur 10 apte à convertir une variation d'une énergie à récupérer en une différence de potentiel entre deux bornes électriques 11,12 par accumulation de charges sur l'une ou l'autre desdites bornes 11,12.

Le convertisseur 10 comprend un empilement de couches 9 avec au moins une première couche 1 en un matériau piézoélectrique : cette première couche 1 comprend deux électrodes métalliques, électriquement connectées aux deux bornes électriques 11,12. Une déformation mécanique (du fait de la variation d'une énergie environnante à récupérer) de cette première couche 1 induit la génération des charges, sur l'une ou l'autre des électrodes, qui seront ensuite récupérées au sein du générateur d'électricité 100.

L'empilement de couches 9 du convertisseur 10 peut être composé de couches additionnelles en différents matériaux, selon le type de fonctionnement dudit convertisseur 10. En particulier, le convertisseur 10 peut être de type magnéto-électrique, apte à convertir une variation d'une énergie magnétique en une différence de potentiel entre ses deux bornes électriques 11,12 ; dans ce cas, comme décrit dans les documents de l'état de la technique évoqués en introduction, l'empilement de couches peut comprendre une deuxième couche 2 en un matériau magnétostrictif, fixée à la première couche 1 en matériau piézoélectrique, selon le plan de référence de cette dernière et sans degré de liberté.

Une variation d'énergie magnétique induit la déformation de la deuxième couche 2 en matériau magnétostrictif, déformation qui est appliquée à la première couche 1 en matériau piézoélectrique solidaire de la deuxième couche 2 dans l'empilement 9.

La variation d'énergie magnétique vient habituellement du mouvement d'une source de champ magnétique 50, ladite source faisant partie du générateur électrique 100. La source de champ magnétique 50 doit pouvoir opérer un mouvement relatif par rapport à l'empilement de couches 9 du convertisseur 10, pour provoquer une variation d'énergie magnétique.

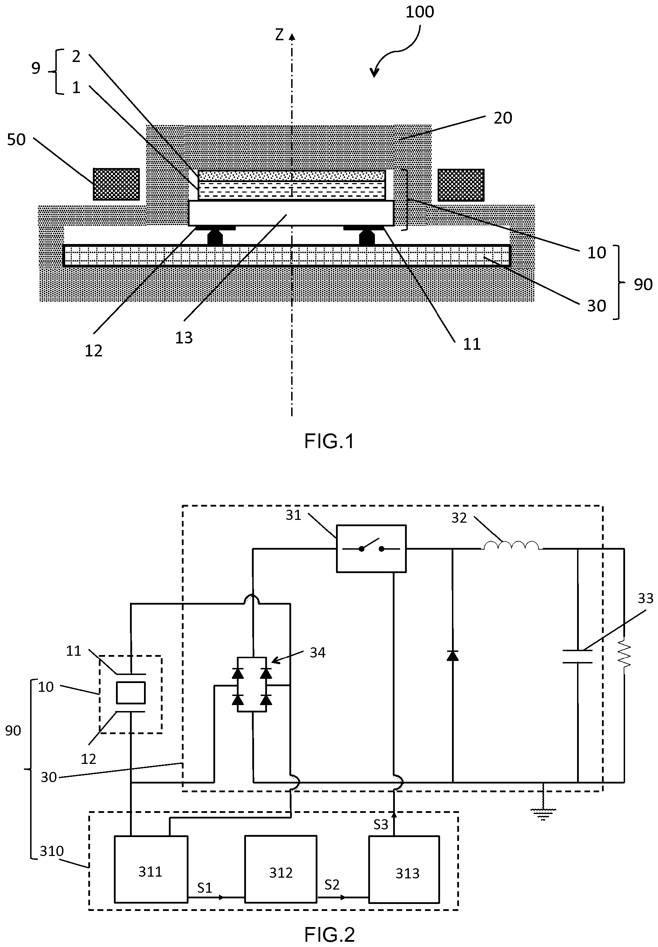

Dans l'exemple de générateur illustré sur la figure 1, le convertisseur 10 est formé par un empilement de couches 9 solidaire d'une couche de connexion 13 assurant la connexion électrique entre les électrodes de la première couche 1 et les bornes électriques 11,12. Le convertisseur 10 présente une forme circulaire dans le plan perpendiculaire à l'axe Z et est maintenu fixe par un support mécanique 20 ; la source de champ magnétique 50 présente une forme annulaire et est apte à effectuer un mouvement de rotation autour de l'axe Z.

A titre d'exemple, ce mouvement de rotation de la source d'énergie magnétique 50 peut être lié à la manipulation d'un bouton variateur (« dimmer ») par un utilisateur (par exemple, pour la commande d'un luminaire) ou à la rotation d'une turbine dans un conduit d'aération.

Ainsi, la variation d'énergie à récupérer est convertie en charges par le convertisseur 10, lesquelles charges sont ensuite récupérées au sein du récupérateur d'énergie 90 grâce à un circuit 30 de collecte des charges, relié électriquement aux deux bornes électriques 11,12 du convertisseur 10. Ce circuit de collecte 30 comprend habituellement un élément inductif 32 (par exemple une bobine) et un interrupteur 31 (figure 2) ; en position fermée, ce dernier permet l'écoulement des charges vers l'élément inductif 32, lequel est connecté à une charge électrique capable de stocker de l'énergie électrique, telle qu'un condensateur 33. Cette énergie électrique peut être utilisée pour alimenter un composant électronique ; pour reprendre les exemples cités plus haut, ledit composant pourra commander l'allumage ou l'extinction d'un luminaire ou encore la mesure, l'affichage ou l'enregistrement de paramètres du conduit d'aération.

La fermeture de l'interrupteur 31 se fait lorsque la différence de potentiel entre les bornes électriques 11,12 atteint un seuil défini. Avantageusement d'un point de vue énergétique, ledit seuil défini est sensiblement le niveau maximum de différence de potentiel atteignable par le convertisseur 10, ceci dans le but de récupérer un maximum de charges et donc un maximum d'énergie.

La demanderesse a constaté qu'en fonctionnement, un générateur d'électricité 100 muni d'un récupérateur d'énergie 90 tel que décrit précédemment génère un cliquetis. S'il n'est pas dérangeant pour les applications de type « dimmer », ce son est beaucoup plus gênant lorsque le générateur d'électricité 100 est utilisé dans des conduits d'aération de locaux habités. En effet, ce cliquetis audible par les utilisateurs des locaux constitue une réelle nuisance sonore.

La demanderesse a mené différentes investigations pour identifier l'origine de ce cliquetis. Différentes hypothèses ont été avancées, dont notamment l'effet de la génération d'impulsions de courant dans l'élément inductif 32 lors de l'ouverture de l'interrupteur 31 du système de collecte 30 pour la récupération des charges, induisant une déformation des spires de la bobine ; une autre hypothèse était l'effet de la décharge très rapide de la première couche 1 de matériau piézoélectrique, générant un changement brutal d'état de contrainte dans ladite première couche.

C'est finalement cette deuxième hypothèse qui a été vérifiée. La demanderesse a établi que cette onde sonore venait principalement des vibrations acoustiques, générées par le brusque changement d'état de contrainte de la première couche 1 de matériau piézoélectrique lors de la récupération des charges : le phénomène de décharge électrique du convertisseur (écoulement des charges de l'une des bornes électriques du convertisseur 10 vers l'élément inductif 32 du circuit de collecte 30) fait passer le potentiel entre ses bornes 11,12 de plusieurs dizaines de volts, voire quelques centaines de volts, à zéro en une fraction de seconde. Le changement d'état de contrainte de la première couche 1 de matériau piézoélectrique est donc brutal et génère des vibrations acoustiques qui se transmettent au convertisseur 10 et à l'ensemble des éléments du générateur 100.

La demanderesse a particulièrement analysé le temps d'écoulement des charges lors de l'ouverture de l'interrupteur 31 afin d'évaluer les possibilités de fractionner la récupération des charges en plusieurs séquences (décharges partielles successives), ceci dans le but de limiter l'écart de contrainte subi par la première couche 1, entre son état avant décharge et son état après décharge.

Il a été observé que le temps pour une décharge complète du convertisseur est de l'ordre de 3 microsecondes.

Ainsi, le récupérateur d'énergie 90 selon l'invention comprend un circuit de commande 310 configuré pour commander une pluralité de séquences de fermeture-ouverture de l'interrupteur 31, lorsque la différence de potentiel atteint un seuil défini, de manière à récupérer les charges par une pluralité de décharges partielles du convertisseur.

L'écoulement séquentiel de parties seulement des charges accumulées sur l'une des bornes électriques 11,12 permet de gérer le changement d'état de contrainte de la première couche 1 en matériau piézoélectrique : pour chaque séquence de décharge, l'écart de contrainte subi par la première couche 1 est limité et ne génère ainsi pas ou peu de vibrations acoustiques.

Avantageusement, pour chaque séquence, l'état fermé de l'interrupteur 31 est commandé par une impulsion générée par le circuit de commande 310. Une impulsion présente typiquement une largeur de 10 à 1000 nanosecondes, deux impulsions de deux séquences consécutives sont typiquement espacées de 10 à 100 microsecondes et le train d'impulsions a une durée totale inférieure à 3ms.

Le choix des caractéristiques des impulsions (largeur, période, nombre d'impulsions) pourra varier en fonction de la valeur de la différence de potentiel aux bornes 11,12 du convertisseur 10, ainsi qu'en fonction du matériau piézoélectrique de la première couche 1.

La largeur des impulsions (durée de fermeture de l'interrupteur 31) doit être adaptée pour récupérer une quantité de charges suffisamment faible pour que l'écart de contrainte subi par la première couche 1 entre l'état avant décharge et l'état après décharge ne génère pas une vibration acoustique ou tout au moins que celle-ci soit faible et non audible (par exemple, inférieure à 25dBA).

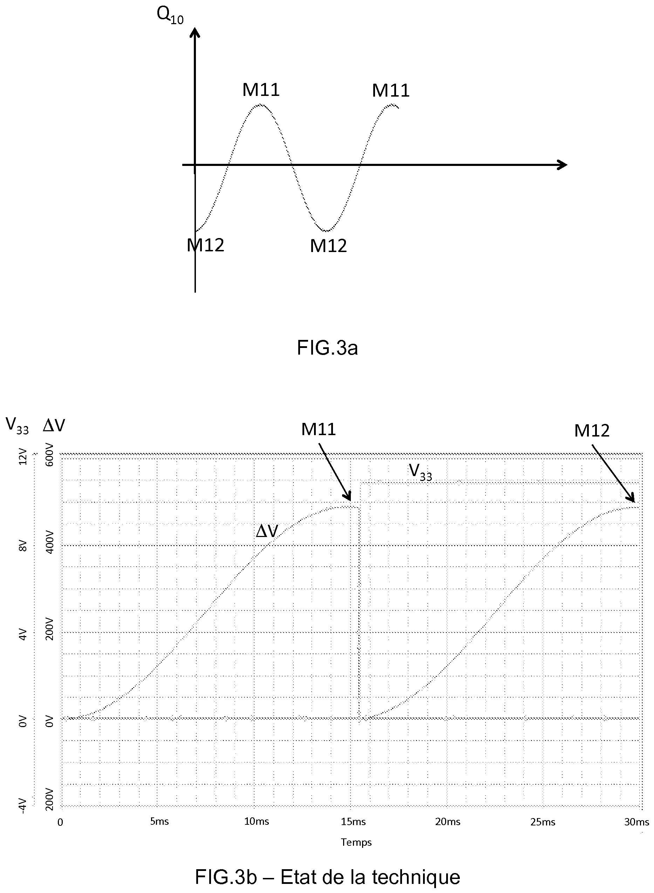

Par ailleurs, pour des questions d'efficacité, il est important de décharger complètement le convertisseur 10. Rappelons que la variation d'énergie à récupérer dans un générateur 100 est souvent périodique, le convertisseur 10 est donc configuré pour générer un maximum de charges alternativement sur l'une puis l'autre des bornes électriques selon une périodicité liée à la période de la variation d'énergie à récupérer. Par exemple, le maximum de charges Q₁₀ sur les bornes électriques 11,12 du convertisseur 10, si les charges ne sont pas collectées, peut varier comme illustré sur la figure 3, en passant alternativement par un pic (maximum) de charges positives M11 sur la borne électrique 11 et par un pic de charges négatives M12 sur la borne électrique 12.

La collecte des charges se fait avantageusement à chaque pic de charges M11, M12 correspondant à un maximum de différence de potentiel ΔV entre les deux bornes électriques 11,12 : cela permet d'exploiter au maximum les cycles de déformations de la première couche 1 en matériau piézoélectrique du convertisseur 10. Alternativement, on peut choisir de déclencher la collecte des charges avant d'atteindre le maximum de charges M11 ou M12, c'est-à-dire pour un seuil défini de différence de potentiel ΔV entre les deux bornes électriques 11,12.

La différence de potentiel ΔV entre les deux bornes électriques 11,12 étant alternativement positive et négative, un pont de diodes 34 (figure 2) permet de la redresser en entrée du circuit de collecte 30.

Comme illustré sur la figure 3b, dès la fermeture de l'interrupteur 31, la décharge du convertisseur 10 (en une séquence, selon l'état de la technique) est très rapide (quelques microsecondes) et correspond au temps de transfert de son énergie vers l'élément inductif 32. La charge de la capacité 33 est un peu plus longue et correspond au transfert de l'énergie de l'élément inductif 32 vers la capacité 33 (environ 100 microsecondes) ; notons que compte tenu de l'échelle du graphe sur la figure 3b, on ne peut discerner la durée d'augmentation de la tension V₃₃ aux bornes de la capacité 33.

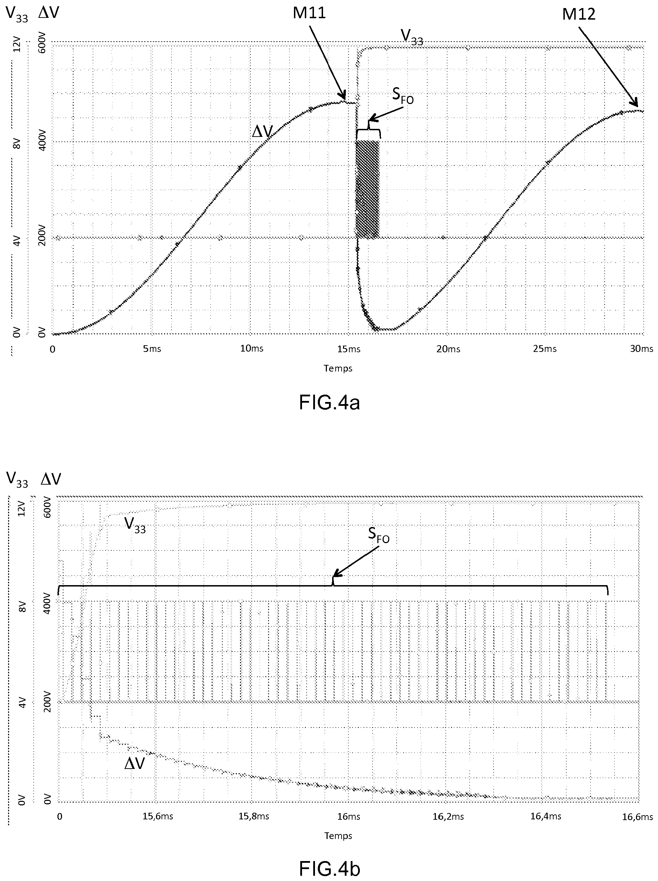

Pour des questions d'efficacité, la décharge complète du convertisseur 10 dans le récupérateur d'énergie 90 selon l'invention implique donc d'enchainer plusieurs impulsions (correspondant à plusieurs séquences de fermeture-ouverture S_{FO} de l'interrupteur 31) pour atteindre une différence de potentiel entre les bornes 11,12 du convertisseur 10 nulle, comme illustré sur les figures 4a et 4b. Comme indiqué précédemment, le nombre d'impulsions pourra donc varier en fonction de la valeur de la différence de potentiel ΔV aux bornes 11,12 du convertisseur 10, ainsi qu'en fonction du matériau piézoélectrique de la première couche 1.

Enfin, la décharge du convertisseur 10 doit être opérée dans un temps limité, avant que les charges accumulées dans le convertisseur 10 ne soient annulées par une déformation inverse de la première couche 1. La période du train d'impulsions doit donc permettre la décharge de toutes les charges accumulées, avant qu'elles ne soient compensées au sein de la première couche 1. En d'autres termes, le temps alloué au train d'impulsions (c'est-à-dire à la pluralité de séquences de fermeture-ouverture de l'interrupteur 31) doit rester très inférieur à la période liée à la variation de l'énergie à récupérer du générateur d'électricité 100.

Mais corrélativement, il faut être attentif à laisser un temps suffisant entre chaque séquence de décharge afin que d'un point de vue mécanique les décharges successives n'aient pas le même effet qu'une décharge en une seule impulsion (génération de vibrations acoustiques), c'est-à-dire que la première couche 1 ait suffisamment de temps de relaxation entre chaque état de contrainte. Ainsi, la largeur (ou les largeurs) des impulsions et la période des impulsions doivent également être choisies de manière à contrôler la dynamique de contrainte subie par la première couche 1 lors des décharges partielles successives.

Avantageusement, le circuit de commande 310 comprend :
- un premier étage 311 de détection du seuil défini de différence de potentiel ; ce premier étage 311 est configuré pour détecter ledit seuil entre les bornes électriques 11,12 du convertisseur 10 et pour générer un signal de déclenchement (appelé premier signal) au niveau d'une première sortie S1 ;
- un deuxième étage 312 de génération des impulsions ; ce deuxième étage 312, connecté à la première sortie S1, est configuré pour générer un signal formant un train d'impulsions (appelé deuxième signal) au niveau d'une deuxième sortie S2, lorsqu'il reçoit le premier signal de déclenchement ;
- et un troisième étage 313 de commande de l'interrupteur 31 ; ce troisième étage 313, connecté à la deuxième sortie S2, est configuré pour transformer le deuxième signal en un signal de commande formant un train d'impulsions : le signal de commande au niveau d'une troisième sortie S3, est apte à commander la pluralité de séquences de fermeture/ouverture de l'interrupteur 31.

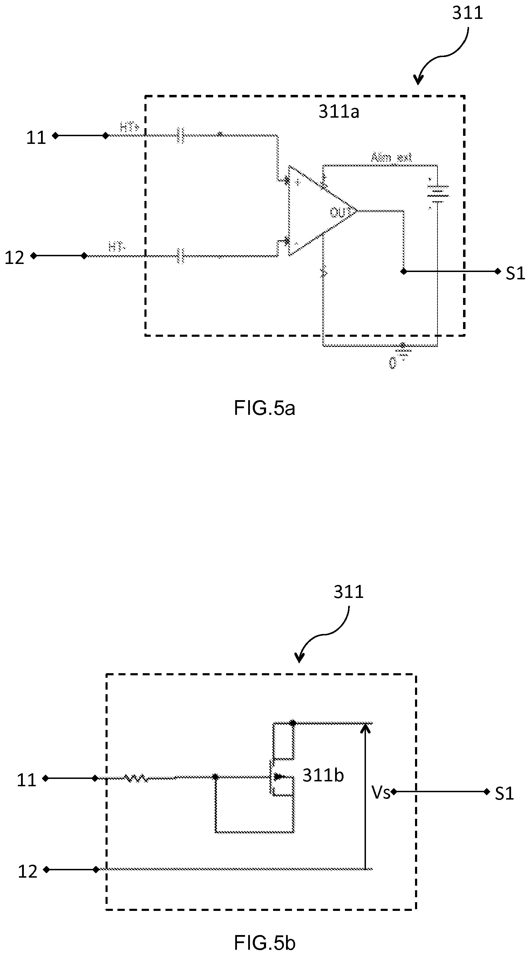

Selon un premier mode de réalisation, le premier étage 311 de détection du seuil défini comprend un comparateur différentiel 311a, connecté aux bornes électriques 11,12 du convertisseur 10 (figure 5a).

Avantageusement d'un point de vue énergétique, on choisit de déclencher l'interrupteur 31 quand la différence de potentiel ΔV aux bornes 11,12 du convertisseur 10 est maximale (valeur crête). Pour cela, il est possible d'utiliser un comparateur différentiel 311a composé d'un amplificateur connecté à une alimentation externe pour mesurer le signal haute tension ΔV. La détection de la crête s'obtient grâce à la dérivée du signal aux bornes du convertisseur 10, dont on détecte le passage par 0. Cette dérivée s'obtient analogiquement grâce à un condensateur dont le courant est la dérivée de la tension appliquée à ses bornes.

Lorsqu'il détecte le seuil défini de tension entre les bornes électriques 11,12 du convertisseur 10, le comparateur différentiel 311a génère le premier signal de déclenchement, au niveau de la sortie de l'amplificateur, dite première sortie S1.

Selon un deuxième mode de réalisation, le premier étage 311 de détection du seuil défini utilise le phénomène d'avalanche dans un semi-conducteur (figure 5b). En basse tension, l'avalanche d'une diode Zener pourrait être utilisée. En haute tension, un transistor 311b peut être avantageusement utilisé. Par exemple, en utilisant l'avalanche entre la grille et le drain d'un transistor MOS. Dans ce cas, afin d'éviter que la source ait un potentiel flottant, elle peut être reliée à la grille (V_{GS} = 0). Tant que la tension (différence de potentiel entre les bornes électriques 11,12 du convertisseur 10) en entrée du premier étage 311 est inférieure à la tension d'avalanche du MOS, le transistor 311b est bloqué et la tension de sortie Vs est nulle. Lorsque la tension en entrée du premier étage 311 dépasse le seuil d'avalanche, la tension de sortie du transistor Vs augmente et peut servir à former le premier signal de déclenchement, au niveau d'une première sortie S1.

Dans le premier ou le deuxième mode de réalisation cités, le deuxième étage 312 du circuit de commande 310 peut comprendre un dispositif logique, connecté à la première sortie S1 et donc apte à recevoir le premier signal de déclenchement.

Pour chaque front montant du premier signal, le dispositif logique est configuré pour générer un deuxième signal formant un train d'impulsions périodique, avec un nombre d'impulsions, une période et un rapport cyclique (ratio entre la durée de l'impulsion et la période du train d'impulsions) déterminés.

Le nombre d'impulsions pourra être compris entre 20 et 150, et comme énoncé précédemment, la largeur des impulsions pourra être comprise entre 10 et 1000 nanosecondes et la période entre 10 et 100 microsecondes.

Le deuxième signal présente ici une largeur d'impulsions, une période d'impulsions et un nombre d'impulsions fixes. En effet, le dispositif logique est prédéfini pour générer le train d'impulsions ce qui fixe les caractéristiques du deuxième signal.

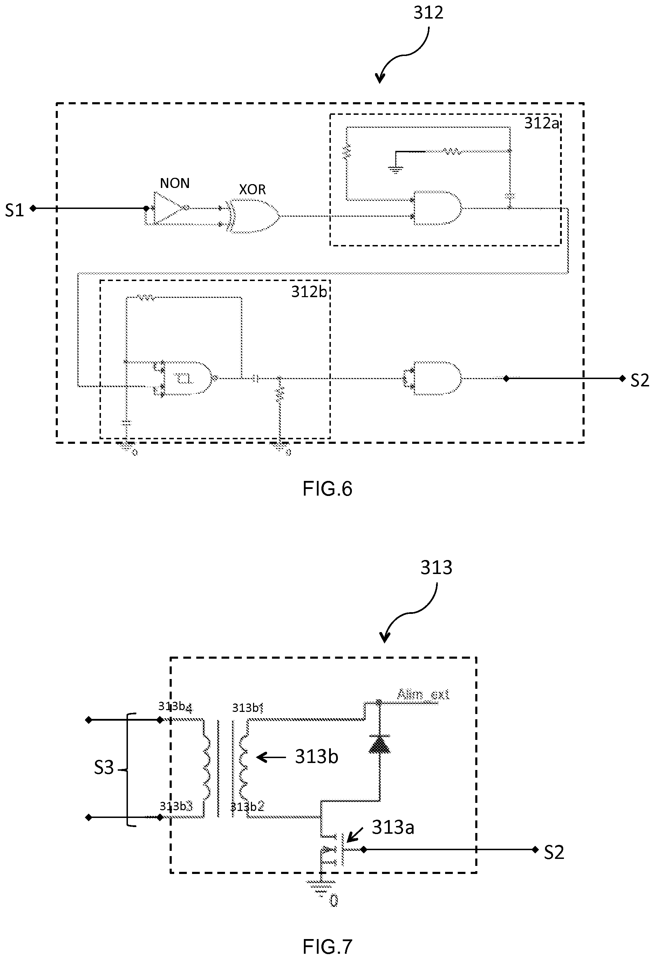

Le dispositif logique peut être réalisé à partir de portes logiques comme illustré sur la figure 6. Il comporte un premier ensemble de portes logiques permettant de générer un signal associé à chaque front montant du premier signal.

Ce signal permet de déclencher un monostable 312a qui définit un temps pendant lequel un train d'impulsions va être généré. Ce monostable 312a déclenche un astable 312b qui va générer ledit train d'impulsions ; l'astable 312b présente typiquement une période de quelques dizaines de microsecondes et un rapport cyclique d'ouverture proche de 50%. Ensuite, la largeur de chaque impulsion est définie au moyen d'un circuit RC.

Le dispositif logique formant le deuxième étage 312 du circuit de commande 310 permet ainsi de générer, au niveau de la deuxième sortie S2, un train d'impulsions présentant les caractéristiques suivantes :
- nombre d'impulsions : 15 à 150,
- largeur des impulsions : 10 à 1000 nanosecondes, par exemple 600 nanosecondes,
- et période : 10 à 100 microsecondes, par exemple 42 microsecondes

La réalisation du deuxième étage 312 du circuit de commande 310 à partir d'un dispositif logique tel que décrit ci-dessus présente l'avantage d'un dispositif autonome, ne nécessitant pas d'apport d'énergie externe pour fonctionner.

Alternativement, le deuxième étage 312 du circuit de commande 310 peut comprendre un microcontrôleur, configuré pour générer un deuxième signal formant un train d'impulsions, au niveau de la deuxième sortie S2. Cette alternative s'applique dans le premier ou le deuxième mode de réalisation énoncé précédemment.

Dans ce cas, le deuxième signal peut présenter une largeur d'impulsions, une période d'impulsions et un nombre d'impulsions variables et ajustables car le microcontrôleur peut être programmé avec des paramètres variables. Cela peut permettre de réduire la durée totale du train d'impulsions. En effet, au début de la décharge (première séquence de fermeture-ouverture de l'interrupteur 31), la différence de potentiel ΔV entre les bornes électriques 11,12 est élevée ; la décharge lors de la première séquence, d'une durée donnée va fournir beaucoup plus d'énergie que lors d'une séquence suivante, de durée identique, du fait de la diminution de la différence de potentiel ΔV. Il peut donc être intéressant de débuter la décharge par des impulsions de faible durée (faible largeur) et de la finir avec des impulsions plus longues (largeur plus grande). Cela permet de récupérer toutes les charges avec moins d'impulsions et dans un temps total plus court. La réduction du nombre d'impulsions permet par la même occasion de réduire les pertes de commutation et la consommation d'énergie pour la commande. Le rendement peut ainsi être amélioré.

A titre d'exemple, le microcontrôleur formant le deuxième étage 312 du circuit de commande 310 peut permettre de générer, au niveau de la deuxième sortie S2, un train d'impulsions présentant les caractéristiques suivantes :
- nombre d'impulsions : < 15,
- largeur des impulsions : de 2 à 1000 à nanosecondes, pouvant être variable de la première à la dernière impulsion,
- et période : de 10 à 100 microsecondes, pouvant être variable de la première à la dernière impulsion.

Selon un troisième mode de réalisation de l'invention, l'ensemble formé par le premier 311 et le deuxième 312 étage peut être réalisé par un microcontrôleur, apte à détecter le seuil défini de différence de potentiel aux bornes électriques 11,12 du convertisseur 10 et lorsque le seuil est détecté à déclencher la génération d'un deuxième signal formant un train d'impulsions, au niveau d'une deuxième sortie S2.

Il faut noter que l'utilisation d'un microcontrôleur dans le premier étage 311 ou dans les premier 311 et deuxième 312 étages du circuit de commande 310 nécessite de l'énergie pour fonctionner et peut donc amputer une partie de l'énergie électrique récupérée par le récupérateur d'énergie 90. Cette énergie consommée par le microcontrôleur n'est alors plus disponible pour alimenter un composant électronique externe. Il est néanmoins possible d'optimiser le fonctionnement de ce microcontrôleur en gérant ses phases de stand by et/ou en rationalisant l'utilisation d'un microcontrôleur ayant d'autres fonctions dans un système voisin.

Dans l'un ou l'autre des modes de réalisation décrits ci-dessus, le troisième étage 313 du circuit de commande 310 comprend un dispositif d'adaptation, connecté à la deuxième sortie S2, pour transformer le deuxième signal en un signal de commande formant un train d'impulsions, apte à commander la pluralité de séquences de fermeture/ouverture de l'interrupteur 31.

Avantageusement, le dispositif d'adaptation comprend un transistor 313a et un transformateur d'impulsion 313b. La grille du transistor 313a est électriquement connectée à la deuxième sortie S2 du deuxième étage 312 du circuit de commande 310. Le deuxième signal formant le train d'impulsion est à basse tension, il est nécessaire de le transformer en un signal de commande à plus haute tension pour commander l'interrupteur 31.

Avantageusement, ledit interrupteur 31 est formé par un transistor capable de tenir une haute tension (correspondant à la différence de potentiel ΔV entre les bornes électriques 11,12 du convertisseur) sur son drain, présentant une faible capacité parasite et pouvant accepter des temps de commutation inférieurs à la centaine de nanosecondes.

Le train d'impulsions de la deuxième sortie S2 commande la grille du transistor 313a. L'entrée 313b1 de l'enroulement primaire du transformateur d'impulsion 313b est reliée à une tension d'alimentation. L'entrée 313b2 est reliée au drain du transistor 313a. La commutation du transistor 313a entraine une variation de flux dans le transformateur d'impulsion et permet la création d'une tension de commande sur le bobinage secondaire (sorties 313b3 & 313b4). Les bornes de sortie 313b3,313b4 du transformateur d'impulsion 313b sont respectivement connectées à la grille et à la source du transistor formant l'interrupteur 31. Le transformateur d'impulsion 313b permet d'isoler l'électronique basse tension (en amont du transformateur 313b) de l'interrupteur 31 sous haute tension.

Le récupérateur d'énergie 90 selon la présente invention a été décrit dans le cas d'un convertisseur 10 magnéto-électrique ; mais l'invention s'adapte à tout type de convertisseur 10 incluant un empilement de couches 9 avec au moins une première couche 1 en un matériau piézoélectrique dont on veut limiter l'amplitude du changement d'état de contrainte et la dynamique de contrainte par une récupération des charges contrôlée via des séquences de fermeture-ouverture (décharges partielles successives) de l'interrupteur 31 situé entre le convertisseur 10 et le circuit de collecte 30.

Par ailleurs, l'invention n'est pas limitée aux modes de réalisation décrits et on peut y apporter des variantes de réalisation sans sortir du cadre de l'invention tel que défini par les revendications.

## Revendications

1. Récupérateur d'énergie (90) comprenant :
• un convertisseur (10) apte à convertir une variation d'une énergie à récupérer en une différence de potentiel entre deux bornes électriques (11,12) par accumulation de charges sur l'une ou l'autre desdites bornes (11,12) ; le convertisseur (10) incluant un empilement de couches (9) avec au moins une première couche (1) en un matériau piézoélectrique ;
• un circuit de collecte (30) relié aux deux bornes électriques (11,12) et comprenant un interrupteur (31), le circuit de collecte (30) étant configuré pour récupérer les charges lorsque l'interrupteur (31) est dans un état fermé ; le convertisseur (10) étant susceptible d'émettre des vibrations acoustiques dans une bande de fréquence audible lorsque le circuit de collecte (30) récupère les charges ;
Le récupérateur d'énergie (90) étant **caractérisé en ce qu'**il comprend un circuit de commande (310) configuré pour commander une pluralité de séquences de fermeture-ouverture (S_{FO}) de l'interrupteur (31), lorsque la différence de potentiel atteint un seuil défini, de manière à récupérer les charges par une pluralité de décharges partielles successives du convertisseur (10) et à limiter l'écart de contrainte subi par la première couche (1) lors de chaque décharge.

2. Récupérateur d'énergie (90) selon la revendication précédente, dans lequel, pour chaque séquence (S_{FO}), l'état fermé de l'interrupteur (31) est commandé par une impulsion générée par le circuit de commande (310).

3. Récupérateur d'énergie (90) selon la revendication précédente, dans lequel une impulsion présente une largeur de 100 à 1000 nanosecondes et dans lequel deux impulsions de deux séquences (S_{FO}) consécutives sont espacées de 10 à 100 microsecondes.

4. Récupérateur d'énergie (90) selon l'une des deux revendications précédentes, dans lequel le circuit de commande (310) comprend un premier étage (311) de détection du seuil défini de différence de potentiel, un deuxième étage (312) de génération des impulsions et un troisième étage (313) de commande de l'interrupteur (31).

5. Récupérateur d'énergie (90) selon la revendication précédente, dans lequel le premier étage (311) comprend un comparateur différentiel (311a), connecté aux bornes électriques (11,12) du convertisseur (10) et apte à générer un premier signal de déclenchement au niveau d'une première sortie (S1).

6. Récupérateur d'énergie (90) selon la revendication précédente, dans lequel le deuxième étage (312) comprend un dispositif logique, connecté à la première sortie (S1) et apte à générer un deuxième signal formant un train d'impulsions, au niveau d'une deuxième sortie (S2).

7. Récupérateur d'énergie (90) selon la revendication précédente, dans lequel le deuxième signal présente une largeur d'impulsions, une période d'impulsions et un nombre d'impulsions fixes.

8. Récupérateur d'énergie (90) selon l'une des deux revendications précédentes, dans lequel le troisième étage (313) comprend un dispositif d'adaptation, connecté à la deuxième sortie (S2), pour transformer le deuxième signal en un signal de commande formant un train d'impulsions, apte à commander la pluralité de séquences de fermeture/ouverture de l'interrupteur (31).

9. Récupérateur d'énergie (90) selon la revendication précédente, dans lequel le dispositif d'adaptation comprend un transistor (313a) et un transformateur d'impulsions (313b).

10. Récupérateur d'énergie (90) selon l'une des revendications 5 à 9 dans lequel le premier signal de déclenchement est généré lorsque la différence de potentiel aux bornes électriques (11,12) du convertisseur (10) est maximale.

11. Récupérateur d'énergie (90) selon la revendication 4, dans lequel le deuxième étage (312) ou l'ensemble formé par le premier (311) et le deuxième étage (312) comprend un microcontrôleur, configuré pour générer un deuxième signal formant un train d'impulsions, au niveau d'une deuxième sortie (S2).

12. Récupérateur d'énergie (90) selon la revendication précédente, dans lequel le deuxième signal présente une largeur d'impulsions, une période d'impulsions et un nombre d'impulsions variables.

13. Récupérateur d'énergie (90) selon l'une des revendications précédentes, dans lequel le convertisseur (10) est un convertisseur magnéto-électrique apte à convertir une variation d'une énergie magnétique en une différence de potentiel entre ses deux bornes électriques (11,12) et dont l'empilement de couches (9) comprend une deuxième couche (2) en un matériau magnétostrictif.

14. Récupérateur d'énergie (90) selon l'une des revendications précédentes, dans lequel le seuil défini correspond à un maximum de différence de potentiel entre les deux bornes électriques (11,12).

15. Générateur d'électricité (100) comprenant une source de champ magnétique (50) et un récupérateur d'énergie (90) selon l'une des revendications précédentes.

## Patentansprüche

1. Energierekuperator (90), umfassend:
• einen Umwandler (10), der zur Umwandlung einer Änderung einer zurückzugewinnenden Energie in eine Potentialdifferenz zwischen zwei elektrischen Anschlüssen (11, 12) durch Akkumulieren von Ladungen an dem einem oder dem anderen der Anschlüsse (11, 12) geeignet ist;
wobei der Umwandler (10) einen Schichtstapel (9) mit mindestens einer ersten Schicht (1) aus einem piezoelektrischen Material umfasst;
• eine Sammelschaltung (30), die mit den zwei elektrischen Anschlüssen (11, 12) verbunden ist und einen Schalter (31) umfasst, wobei die Sammelschaltung (30) eingerichtet ist, um die Ladungen zurückzugewinnen, wenn der Schalter (31) in einem geschlossenen Zustand ist;
wobei der Umwandler (10) in der Lage ist, akustische Schwingungen in einem hörbaren Frequenzband zu senden, wenn die Sammelschaltung (30) die Ladungen zurückgewinnt;
wobei der Energierekuperator (90) **dadurch gekennzeichnet ist, dass** er eine Steuerschaltung (310) umfasst, die eingerichtet ist, um eine Vielzahl von Schließ-Öffnungs-Sequenzen (S_{FO}) des Schalters (31) zu steuern, wenn die Potentialdifferenz einen festgelegten Grenzwert erreicht, so dass die Ladungen von einer Vielzahl aufeinanderfolgender Teilentladungen des Umwandlers (10) zurückgewonnen werden und die Spannungsabweichung, die die erste Schicht (1) während jeder Entladung erfährt, begrenzt wird.

2. Energierekuperator (90) nach vorangehendem Anspruch, wobei für jede Sequenz (S_{FO}) der geschlossene Zustand des Schalters (31) von einem von der Steuerschaltung (310) erzeugten Impuls gesteuert wird.

3. Energierekuperator (90) nach vorangehendem Anspruch, wobei ein Impuls eine Breite von 100 bis 1'000 Nanosekunden hat und wobei zwei Impulse von zwei aufeinanderfolgenden Sequenzen (S_{FO}) 10 bis 100 Mikrosekunden beabstandet sind.

4. Energierekuperator (90) nach einem der zwei vorangehenden Ansprüche, wobei die Steuerschaltung (310) eine erste Stufe (311) zur Erfassung des festgelegten Potentialdifferenzgrenzwerts, eine zweite Stufe (312) zur Impulserzeugung und eine dritte Stufe (313) zur Steuerung des Schalters (31) umfasst.

5. Energierekuperator (90) nach vorangehendem Anspruch, wobei die erste Stufe (311) einen Differentialkomparator (311a) umfasst, der mit den elektrischen Anschlüssen (11, 12) des Umwandlers (10) verbunden ist und zur Erzeugung eines erstes Triggersignals im Bereich eines ersten Ausgangs (S1) geeignet ist.

6. Energierekuperator (90) nach vorangehendem Anspruch, wobei die zweite Stufe (312) eine Logikvorrichtung umfasst, die mit dem ersten Ausgang (S1) verbunden ist und zur Erzeugung eines zweites Signals , das eine Impulsfolge im Bereich eines zweiten Ausgangs (S2) bildet, geeignet ist.

7. Energierekuperator (90) nach vorangehendem Anspruch, wobei das zweite Signal eine Impulsbreite, eine Impulsperiode und eine Anzahl von Impulsen aufweist, die fest sind.

8. Energierekuperator (90) nach einem der zwei vorangehenden Ansprüche, wobei die dritte Stufe (313) eine mit dem zweiten Ausgang (S2) verbundene Anpassungsvorrichtung zum Umwandeln des zweiten Signals in ein eine Impulsfolge bildendes Steuersignal umfasst, das zur Steuerung der Vielzahl von Schließ-/Öffnungssequenzen des Schalters (31) geeignet ist.

9. Energierekuperator (90) nach vorangehendem Anspruch, wobei die Anpassungsvorrichtung einen Transistor (313a) und einen Impulstransformator (313b) umfasst.

10. Energierekuperator (90) nach einem der Ansprüche 5 bis 9, wobei das erste Triggersignal erzeugt wird, wenn die Potentialdifferenz an den elektrischen Anschlüssen (11, 12) des Umwandlers (10) maximal ist.

11. Energierekuperator (90) nach Anspruch 4, wobei die zweite Stufe (312) oder die aus der ersten (311) und der zweiten Stufe (312) gebildete Einheit einen Mikrocontroller umfasst, der eingerichtet ist, um ein zweites Signal zu erzeugen, das eine Impulsfolge im Bereich eines zweiten Ausgangs (S2) bildet.

12. Energierekuperator (90) nach vorangehendem Anspruch, wobei das zweite Signal eine Impulsbreite, eine Imulsperiode und Anzahl von Impulsen aufweist, die variabel sind.

13. Energierekuperator (90) nach einem der vorangehenden Ansprüche, wobei der Umwandler (10) ein magnetelektrischer Umwandler ist, der zur Umwaldung einer Änderung einer magnetischen Energie in eine Potentialdifferenz zwischen seinen zwei elektrischen Anschlüssen (11, 12) geeignet ist und dessen Schichtstapel (9) eine zweite Schicht (2) aus einem magnetostriktiven Material umfasst.

14. Energierekuperator (90) nach einem der vorangehenden Ansprüche, wobei der festgelegte Grenzwert einer maximalen Potentialdifferenz zwischen den zwei elektrischen Anschlüssen (11, 12) entspricht.

15. Stromgenerator (100), umfassend eine Magnetfeldquelle (50) und einen Energierekuperator (90) nach einem der vorangehenden Ansprüche.

## Claims

1. Energy recovery device (90) comprising:
• a converter (10) capable of converting a variation of an energy to be recovered into a difference in potential between two electrical terminals (11, 12) by accumulating loads on either of said terminals (11, 12); the converter (10) including a stack of layers (9) with at least a first layer (1) made of a piezoelectric material;
• a collection circuit (30) connected to the two electrical terminals (11, 12) and comprising a switch (31), the collection circuit (30) being configured to recover the loads when the switch (31) is in a closed state; the converter (10) being capable of emitting acoustic vibrations in an audible frequency band when the collection circuit (30) recovers the loads;
the energy recovery device (90) being **characterized in that** it comprises a control circuit (310) configured to control a plurality of closing-opening sequences (S_{FO}) of the switch (31), when the difference in potential reaches a defined threshold, so as to recover the loads by a plurality of successive partial discharges of the converter (10) and to limit the stress deviation to which the first layer (1) is subjected during each discharge.

2. Energy recovery device (90) according to the preceding claim, wherein, for each sequence (S_{FO}), the closed state of the switch (31) is controlled by a pulse generated by the control circuit (310).

3. Energy recovery device (90) according to the preceding claim, wherein one pulse has a width of 100 to 1000 nanoseconds and wherein two pulses of two consecutive sequences (S_{FO}) are spaced apart by 10 to 100 microseconds.

4. Energy recovery device (90) according to either of the two preceding claims, wherein the control circuit (310) comprises a first stage (311) for detecting the defined threshold of the difference in potential, a second stage (312) for generating the pulses and a third stage (313) for controlling the switch (31).

5. Energy recovery device (90) according to the preceding claim, wherein the first stage (311) comprises a differential comparator (311a) which is connected to the electrical terminals (11, 12) of the converter (10) and is capable of generating a first trigger signal at a first output (S1).

6. Energy recovery device (90) according to the preceding claim, wherein the second stage (312) comprises a logic device, which is connected to the first output (S1) and is capable of generating a second signal which forms a train of pulses, at a second output (S2).

7. Energy recovery device (90) according to the preceding claim, wherein the second signal has a fixed pulse width, pulse period and number of pulses.

8. Energy recovery device (90) according to either of the two preceding claims, wherein the third stage (313) comprises an adaptation device, which is connected to the second output (S2), for transforming the second signal into a control signal which forms a train of pulses and is capable of controlling the plurality of closing/opening sequences of the switch (31).

9. Energy recovery device (90) according to the preceding claim, wherein the adaptation device comprises a transistor (313a) and a pulse transformer (313b).

10. Energy recovery device (90) according to any of claims 5 to 9, wherein the first trigger signal is generated when the difference in potential at the electrical terminals (11, 12) of the converter (10) is at a maximum.

11. Energy recovery device (90) according to claim 4, wherein the second stage (312) or the assembly formed by the first (311) and the second stage (312) comprises a microcontroller, which is configured to generate a second signal which forms a train of pulses, at a second output (S2).

12. Energy recovery device (90) according to the preceding claim, wherein the second signal has a variable pulse width, pulse period and number of pulses.

13. Energy recovery device (90) according to any of the preceding claims, wherein the converter (10) is a magneto-electric converter capable of converting a variation of a magnetic energy into a difference in potential between its two electrical terminals (11, 12), and the stack of layers (9) of said converter comprises a second layer (2) made of a magnetostrictive material.

14. Energy recovery device (90) according to any of the preceding claims, wherein the defined threshold corresponds to a maximum difference in potential between the two electrical terminals (11, 12).

15. Electricity generator (100) comprising a magnetic field source (50) and an energy recovery device (90) according to any of the preceding claims.
